# EUROPEAN PATENT APPLICATION

(11) **EP 3 244 308 A1**
(43) Date of publication of application: **15.11.2017**
(21) Application number: 15876768.1
(22) Date of filing: 17.11.2015
(51) Int. Cl.: G06F 9/50, G06F 12/02

(54) **MICROCOMPUTER FOR MICROPHONE**

(30) Priority: 07.01.2015 JP 2015001671
(71) Applicant: Panasonic Intellectual Property Management Co., Ltd., Osaka-shi, Osaka 540-6207 (JP)
(72) Inventor: TAKEMOTO, Makoto, Osaka 540-6207 (JP); KATO, Akihiro, Osaka 540-6207 (JP)
(74) Representative: Schwabe - Sandmair - Marx
(86) International application number: PCT/JP2015/005733
(87) International publication number: WO 2016/110887

(57) **Abstract**

The objective of the present invention is to make it possible to execute each of a plurality of application programs without taking into account the addresses of the programs. A microcomputer (100) is provided with: a program memory (108) which stores a plurality of microphone programs executed by a digital signal processing circuit (104); an address control circuit (109) which controls addresses in the program memory; a program address register (110) which stores the addresses of the microphone programs; and a program size register (111) which stores the sizes of the microphone programs. The address control circuit (109) calculates the addresses in the program memory on the basis of the program address register (110) and the program size register (111).

## Description

### Technical Field

The present invention relates to a microcomputer for a microphone that executes a plurality of application programs.

### Background Art

Microphones that can achieve various directional characteristics by preparing two or more microphone elements, and adjusting, for example, a distance between the microphone elements, and/or amplitude, phase, and/or delay amount during signal synthesis (variable-directivity microphones) have been known. As the directional characteristics of a microphone, there are, for example, omnidirectional, bidirectional, unidirectional, narrow-angle directivity, and so forth. It is desirable to choose optimal one from the directional characteristics for every sound pick-up setting by taking account of a position of a sound source to pick-up or an unintended sound field.

In the above microphones, microcomputers are used. A microcomputer is equipped with, for example, a microphone element, an amplifier, an analog-to-digital converter (ADC), a digital signal processor (DSP), a digital-to-analog converter (DAC), a system controller, and/or a program memory.

For instance, Patent Literature (hereinafter, referred to as PTL) 1 discloses a single-chip microcomputer that is adaptable to a plurality of application programs. In a case where any of a plurality of application programs stored in an internal memory is executed, the single-chip microcomputer of PTL 1 sets differences between staring addresses of the application programs and a predetermined base address, and executes the application program based on the difference. This allows, when executing the application programs in a single-chip microcomputer, the CPU to execute them without taking account of addresses at which the respective application programs are located and that are different for the respective application programs.

### Citation List

### Patent Literature

PTL 1
Japanese Patent Application Laid-Open No. 2007-200350

### Summary of Invention

### Technical Problem

In general, a plurality of application programs stored in an internal memory individually vary in size. In the single-chip microcomputer of PTL 1, however, there is a problem in that although the addresses of application programs are taken into account as mentioned above, the sizes of the application programs are not taken into account.

An object of the present invention is to provide a microcomputer for a microphone that can execute application programs more effectively without taking account of addresses different for the respective application programs.

### Solution to Problem

A microcomputer for a microphone according to an embodiment of the present invention includes: an input amplifier that amplifies an analog signal from the microphone; an analog-to-digital converter that converts the analog signal output from the input amplifier to a digital signal; a digital signal processor that processes the digital signal output from the analog-to-digital converter; a digital-to-analog converter that converts the digital signal output from the digital signal processor to an analog signal; an output amplifier that amplifies the analog signal output from the digital-to-analog converter and outputs the analog signal to a speaker; a program memory that stores a plurality of microphone programs to be executed by the digital signal processor; an address control circuit that controls an address of the program memory; a program address register that stores an address of the microphone program; and a program size register that stores a size of the microphone program, in which the address control circuit is configured to calculate the address of the program memory based on the program address register and the program size register.

### Advantageous Effects of Invention

According to the present invention, application programs can be executed more effectively without taking account of addresses different for the respective application programs.

### Brief Description of Drawings

FIG. 1 is a block diagram that illustrates an example configuration of a microcomputer for a microphone according to an embodiment of the present invention;
FIG. 2 illustrates an example of memory map for a program memory of the microcomputer for a microphone according to the embodiment of the present invention;
FIG. 3 illustrates an example of register map for a program address register of the microcomputer for a microphone according to the embodiment of the present invention;
FIG. 4 illustrates an example of register map for a program size register of the microcomputer for a microphone according to the embodiment of the present invention; and
FIG. 5 is a flow chart that illustrates processing in an address control circuit of the microcomputer for a microphone according to the embodiment of the present invention.

### Description of Embodiments

In the following, embodiments of the present invention will be described with reference to the accompanying drawings.

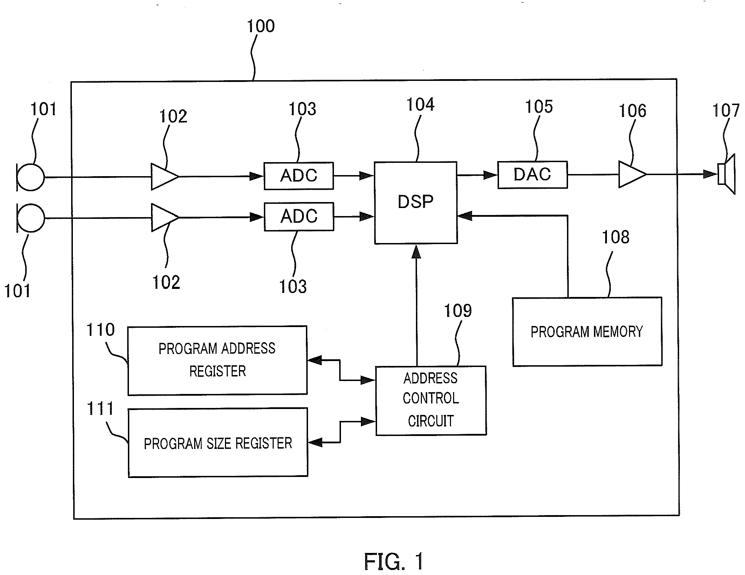

First, a configuration example of a program switchable function-equipped microcomputer 100 for a microphone (hereinafter referred to as microcomputer 100) according to an embodiment of the present invention will be described with reference to FIG. 1. FIG. 1 is a block diagram that illustrates the configuration example of microcomputer 100.

As illustrated in FIG. 1, microcomputer 100 is connected to microphones 101 and speaker 107. Also, microcomputer 100, as illustrated in FIG. 1, includes input amplifiers 102, analog-to-digital converters (ADC) 103, digital signal processor (DSP) 104, digital-to-analog converter (DAC) 105, and output amplifier 106.

Microphones 101 convert sound to electric signals, and output the electric signals (hereinafter referred to as analog signals) to input amplifiers 102. In FIG. 1, as an example, two microphones 101 are included.

Input amplifiers 102 amplify the analog signals output from microphones 101, and output the analog signals to analog-to-digital converters 103. In FIG. 1, as an example, two input amplifiers 102 are included corresponding to two microphones 101.

Analog-to-digital converters (ADC) 103 convert the analog signals output from input amplifiers 102 to digital signals, and output the digital signals to digital signal processor 104. In FIG. 1, as an example, two analog-to-digital converters 103 are included corresponding to two microphones 101 and two input amplifiers 102.

Digital signal processor (DSP) 104 processes the digital signals output from analog-to-digital converters 103 by executing a microphone program (application program) to be mentioned hereinafter, and outputs the digital signal to digital-to-analog converter 105.

Digital-to-analog converter (DAC) 105 converts the digital signal output from digital signal processor 104 to an analog signal, and outputs the analog signal to output amplifier 106.

Output amplifier 106 amplifies the analog signal output from digital-to-analog converter 105, and outputs the analog signal to speaker 107.

Speaker 107 converts the analog signal output from output amplifier 106 to sound.

Further, as illustrated in FIG. 1, microcomputer 100 includes program memory 108, address control circuit 109, program address register 110, and program size register 111.

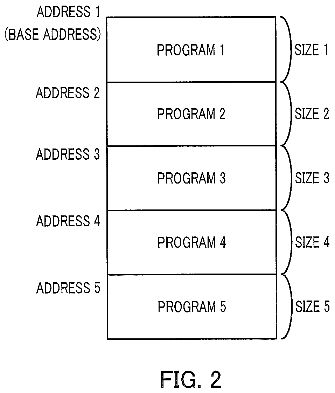

Program memory 108 stores a plurality of microphone programs (see FIG. 2) in advance that are to be executed by digital signal processor 104. Program memory 108 may be, for example, read-only memory (ROM), high-capacity non-volatile memory, such as flash memory or electrically erasable programmable read-only memory (EEPROM), or other storage devices.

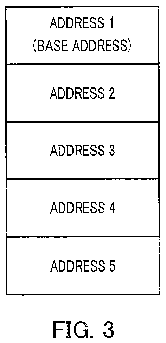

Program address register 110 stores addresses (see FIG. 3) of the microphone programs in advance.

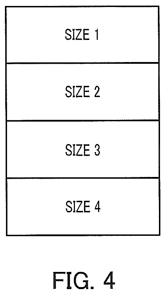

Program size register 111 stores sizes (see FIG. 4) of the microphone programs in advance.

Address control circuit 109 reads program address register 110 and program size register 111, calculates a starting address of program memory 108 based on them, and writes the starting address in program address register 110. Then, address control circuit 109 reads the starting address of program memory 108 written in program address register 110, and outputs the starting address to digital signal processor 104. After that, digital signal processor 104 reads, from program memory 108, a microphone program whose starting address is output from address control circuit 109, and executes the microphone program.

Next, a memory map of program memory 108 of microcomputer 100 will be described with reference to FIG. 2. FIG. 2 illustrates an example of the memory map of program memory 108.

Program memory 108 stores a plurality of microphone programs (application programs) in advance that are to be executed by digital signal processor 104. As illustrated in FIG. 2, program memory 108 stores, for example, program 1, program 2, program 3, program 4, and program 5.

FIG. 2 illustrates that a starting address of program 1 is address 1 (base address), and a program size of program 1 is size 1.

Also, FIG. 2 illustrates that a starting address of program 2 is address 2, and a program size of program 2 is size 2.

Further, FIG. 2 illustrates that a starting address of program 3 is address 3, and a program size of program 3 is size 3.

Further, FIG. 2 illustrates that a starting address of program 4 is address 4, and a program size of program 4 is size 4.

Furthermore, FIG. 2 illustrates that a starting address of program 5 is address 5, and a program size of program 5 is size 5.

Next, a register map of program address register 110 of microcomputer 100 will be described with reference to FIG. 3. FIG. 3 illustrates an example of the register map of program address register 110.

Program address register 110 stores addresses of a plurality of microphone programs in advance. As illustrated in FIG. 3, program address register 110 stores, for example, a starting address or address 1 of program 1, a starting address or address 2 of program 2, a starting address or address 3 of program 3, a starting address or address 4 of program 4, and a starting address or address 5 of program 5.

Next, a register map of program size register 111 of microcomputer 100 will be described with reference to FIG. 4. FIG. 4 illustrates an example of the register map of program size register 111.

Program size register 111 stores program sizes of a plurality of microphone programs in advance. As illustrated in FIG. 4, program size register 111 stores a program size or size 1 of program 1, a program size or size 2 of program 2, a program size or size 3 of program 3, and a program size or size 4 of program 4.

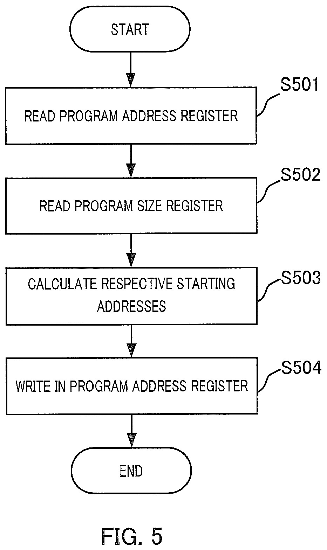

Next, processing operations of address control circuit 109 of microcomputer 100 will be described with reference to FIG. 5. FIG. 5 is a flow chart that illustrates an example of the processing operations of address control circuit 109.

First, address control circuit 109 reads program address register 110 (step S501). For example, addresses 1 to 5 of program address register 110 are read.

Then, address control circuit 109 reads program size register 111 (step S502). For example, sizes 1 to 4 of program size register 111 are read.

After that, address control circuit 109 calculates starting addresses of program memory 108 based on addresses 1 to 5 of program address register 110 and sizes 1 to 4 of program size register 111 (step S503).

Here, specific examples of the above calculation processing will be described.

For example, address control circuit 109 directly sets address 1 of program address register 110 as address 1.

Also, address control circuit 109, for example, adds address 1 of program address register 110 and size 1 of program size register 111, and sets the result of addition as address 2.

Further, address control circuit 109, for example, adds address 2 of program address register 110 and size 2 of program size register 111, and sets the result of addition as address 3.

Further, address control circuit 109, for example, adds address 3 of program address register 110 and size 3 of program size register 111, and sets the result of addition as address 4.

Furthermore, address control circuit 109, for example, adds address 4 of program address register 110 and size 4 of program size register 111, and sets the result of addition as address 5.

Through the above calculation processing, address control circuit 109 sets addresses 1 to 5 as starting addresses of program memory 108.

Then, address control circuit 109 writes the set addresses of program memory 108 in program address register 110 (step S504). For example, addresses 1 to 5 set through the above calculation processing are written. This updates program address register 110.

After that, address control circuit 109 reads starting addresses (for example, addresses 1 to 5) of program memory 108 written in program address register 110, and outputs them to digital signal processor 104. Digital signal processor 104, then, reads microphone programs based on the starting addresses of program memory 108 output from address control circuit 109, and executes the read microphone programs.

As described above, according to the embodiment of the present invention, a digital signal processor can execute application programs more effectively without taking account of addresses different for the respective application programs.

In addition, according to the embodiment of the present invention, each application program can be independently developed without taking account of addresses in which respective application programs are located on a microcomputer, and complicated mapping operations do not result when each application program is located on a microcomputer.

The disclosure of Japanese Patent Application No. 2015-001671, filed on January 7, 2015, including the specification, drawings and abstract, is incorporated herein by reference in its entirety.

### Industrial Applicability

The present invention relates to changing of application programs for switching the directional characteristics of a microphone, and is usable in a microcomputer for a microphone that stores a plurality of application programs in an internal memory and includes a built-in digital signal processor (DSP) that executes them.

### Reference Signal List

- 100: Microcomputer
- 101: Microphone
- 102: Input amplifier
- 103: Analog-to-digital converter (ADC)
- 104: Digital signal processor (DSP)
- 105: Digital-to-analog converter (DAC)
- 106: Output amplifier
- 107: Speaker
- 108: Program memory
- 109: Address control circuit
- 110: Program address register
- 111: Program size register

## Claims

1. A microcomputer for a microphone, comprising:
an input amplifier that amplifies an analog signal from the microphone;
an analog-to-digital converter that converts the analog signal output from the input amplifier to a digital signal;
a digital signal processor that processes the digital signal output from the analog-to-digital converter;
a digital-to-analog converter that converts the digital signal output from the digital signal processor to an analog signal;
an output amplifier that amplifies the analog signal output from the digital-to-analog converter and outputs the analog signal to a speaker;
a program memory that stores a plurality of microphone programs to be executed by the digital signal processor;
an address control circuit that controls an address of the program memory;
a program address register that stores an address of the microphone program; and
a program size register that stores a size of the microphone program,
wherein the address control circuit calculates the address of the program memory based on the program address register and the program size register.

2. The microcomputer for a microphone according to claim 1, wherein the program memory stores a plurality of the microphone programs in advance.

3. The microcomputer for a microphone according to claim 2, wherein the program address register stores the address of the microphone program in advance.

4. The microcomputer for a microphone according to claim 2, wherein the program size register stores the size of the microphone program in advance.

5. The microcomputer for a microphone according to claim 2, wherein the address control circuit calculates the address of the program memory by adding the address of the microphone program stored in the program address register and the size of the microphone program stored in the program size register.

6. The microcomputer for a microphone according to claim 5, wherein the address control circuit writes the calculated address of the program memory in the program address register.

7. The microcomputer for a microphone according to claim 6, wherein:
the address control circuit reads the address of the program memory written in the program address register, and outputs the address to the digital signal processor; and
the digital signal processor reads the microphone program from the program memory based on the address of the program memory output from the address control circuit, and executes the program.
